# EUROPEAN PATENT APPLICATION

(11) **EP 1 939 924 A2**
(43) Date of publication of application: **02.07.2008**
(21) Application number: 07254889.4
(22) Date of filing: 17.12.2007
(51) Int. Cl.: H01J 37/304, H01J 37/305, C23C 14/30, C23C 14/54, H01J 37/30

(54) **Electron beam physical vapor deposition apparatus and processes**

(30) Priority: 29.12.2006 US 647960
(71) Applicant: United Technologies Corporation, Hartford, CT 06101 (US)
(72) Inventor: Barabash, Yurity M., Kyiv 02068 (UA); Belousov, Igor V., Kyiv 03150 (UA); Kononenko, Yurity G., Kyiv 01024 (UA); Mullin, Richard S., Cromwell, CT 06416 (US)
(74) Representative: Leckey, David Herbert

(57) **Abstract**

A process for adjusting a feed rate in an electron-beam physical vapor deposition apparatus (10) includes the steps of positioning a target (16) at a first height within a chamber (12) of an electron-beam physical vapor deposition apparatus (12); feeding the target (16) at a rate into a beam of electrons generated by an electron gun of the electron-beam physical vapor deposition apparatus (10); evaporating the target (16) with the beam of electrons; monitoring the first height by measuring a difference between a first light intensity and a second light intensity of at least one image of the target using an optical sensor (22) disposed proximate to the chamber (12); determining a change in the first height; and adjusting a target feed rate.

## Description

### FIELD OF THE INVENTION

The invention relates to electron beam physical vapor deposition apparatus and, more particularly, to independent spatial position stabilization of a target in an electron beam physical vapor deposition apparatus.

### BACKGROUND OF THE INVENTION

Chemical variations, e.g., lamination, across the cross-section of multi-component condensates are one of the main problems encountered when utilizing Electron-Beam Physical Vapor Deposition (EB-PVD) techniques. These chemical variations are caused by instability in EB-PVD process parameters. For instance, one main parameter whose instability can cause such significant chemical variations is the relative level of the molten pool within the EB-PVD chamber. Theoretically, when the molten pool level is maintained at a fixed height throughout the EB-PVD process, lamination may be significantly reduced or eliminated. However, in current EB-PVD apparatus, the molten pool level is maintained manually by the EB-PVD operator. As a result, the relative level of the molten pool remains a potentially instable operating parameter.

Therefore, there exists a need for an EB-PVD apparatus equipped with an independent system designed to monitor and maintain a constant relative level of the molten pool within the EB-PVD chamber.

### SUMMARY OF THE INVENTION

In accordance with one aspect of the present invention, process for adjusting a feed rate in an electron-beam physical vapor deposition apparatus broadly comprises positioning a target at a first height within a chamber of an electron-beam physical vapor deposition apparatus; feeding the target at a rate into a beam of electrons generated by an electron gun of the electron-beam physical vapor deposition apparatus; evaporating the target with the beam of electrons; monitoring the first height by measuring a difference between a first light intensity and a second light intensity of at least one image of the target using an optical sensor disposed proximate to the chamber; determining a change in the first height; and adjusting a target feed rate.

In accordance with another aspect of the present invention, an electron beam physical vapor deposition apparatus broadly comprises a chamber housing the following: a target station; means for moving the target station; and a window; an optical sensor disposed in connection with the chamber and proximate to the window, wherein the optical sensor comprises means for measuring a difference between a first light intensity and a second light intensity of at least one image of a target; an electron gun disposed in connection with the chamber; and an electron module connected to the optical sensor and the means for moving the target station.

In accordance with yet another aspect of the present invention, a process for manufacturing multi-component condensates free of lamination using an electron-beam physical vapor deposition apparatus broadly comprises positioning a multi-component target at a first height within a chamber of an electron-beam physical vapor deposition apparatus; feeding the multi-component target at a rate into a beam of electrons generated by an electron gun of the electron-beam physical vapor deposition apparatus; evaporating the multi-component target with the beam of electrons into at least a first component evaporant and a second component evaporant; monitoring the first height by measuring a difference between a first light intensity and a second light intensity of at least one image of the multi-component target using an optical sensor disposed proximate to the chamber; determining a change in the first height; adjusting a multi-component target feed rate to evenly deposit the first component evaporant and the second component evaporant upon a substrate; and forming a multi-component condensate free of lamination.

The details of one or more embodiments of the invention are set forth in the accompanying drawings and the description below. Other features and advantages of the invention will be apparent from the description and drawings, and from the claims.

### BRIEF DESCRIPTION OF THE DRAWINGS

FIG. 1 is a representation of an electron beam physical vapor deposition apparatus of the present invention;
FIG. 2 is a representation of a flow chart of an electron module for use with the electron beam physical vapor deposition apparatus of FIG. 1;
FIG. 3 is a representation of a schematic of a sensor for use with the electron beam physical vapor deposition apparatus of FIG. 1;
FIG. 4A is a microphotograph taken at a magnification of 100x of a Ti-6Al-4V EBPVD condensate obtained with an electron beam physical vapor deposition apparatus of the prior art;
FIG. 4B is a microphotograph taken at a magnification of 500x of a Ti-6Al-4V EBPVD condensate obtained with an electron beam physical vapor deposition apparatus of the prior art;
FIG. 5A is a microphotograph taken at a magnification of 100x of a Ti-6Al-4V EBPVD condensate obtained with an electron beam physical vapor deposition apparatus of the present invention; and
FIG. 5B is a microphotograph taken at a magnification of 500x of a Ti-6Al-4V EBPVD condensate obtained with an electron beam physical vapor deposition apparatus of the present invention.

Like reference numbers and designations in the various drawings indicate like elements.

### DETAILED DESCRIPTION

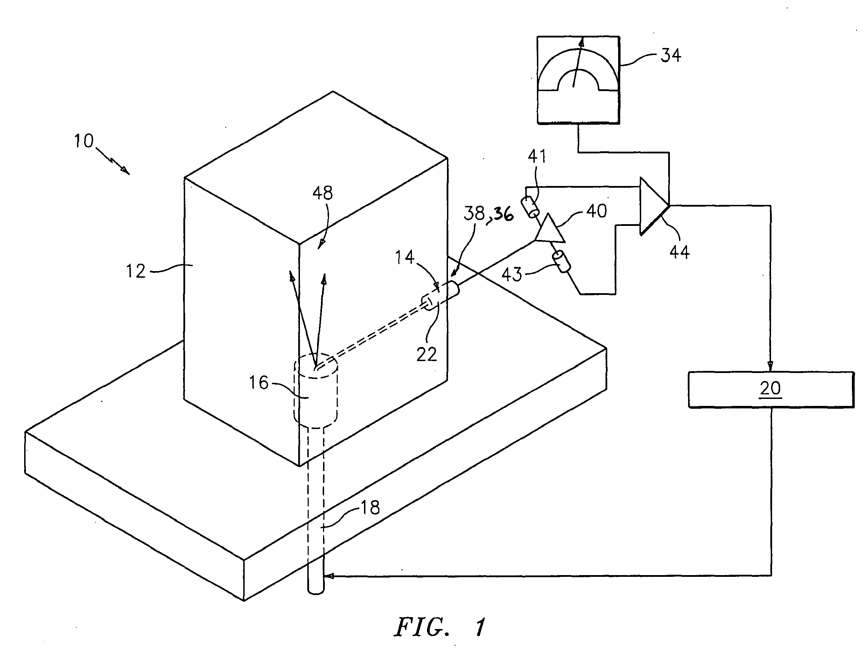

Referring now to FIG. 1, a representation of an electron beam physical vapor deposition apparatus 10 (hereinafter "EBPVD 10") of the present invention is shown. The EBPVD 10 generally includes a chamber 12 having a window 14 that houses a target station 16 disposed in connection with a means for moving the target station 18 having a power supply (not shown) and an actuation mechanism (not shown). An electron module 20 may be disposed outside the exterior of the chamber 12 and in connection with the means for moving the target station 18. An optical sensor 22 may be disposed proximate to the window 14 and in connection with the chamber 12. More particularly, the optical sensor 22 may be mounted externally to the chamber 12 and disposed against the window 14. The window 14 may comprise a quartz window having a diameter of about 30 millimeters (mm) to about 40 mm, or about 30 mm to about 35 mm, and a thickness of about 4 mm to about 10 mm, or about 6 mm to about 8 mm. In addition, the window 14 may also include a fibrous material (not shown) disposed upon its surface within the chamber 12 in amount sufficient to prevent the evaporated coating flux from depositing upon the window 14. The target station 16 may be a receptacle designed to hold the target being evaporated while providing a line-of-sight for the optical sensor to the surface of the target.

The optical sensor 22 may comprise a gas dynamic filter 36, a focusing lens 38, a separating prism 40, and a first photodetector 41 and a second photodetector 43, each connected to a preamplifier 44. The gas dynamic filter 36 may be a substantially tubular structure having a grid disposed therein. The structure may be about 150 mm in length with an internal diameter of about 25 mm. The grid disposed within the structure may possess a mesh thickness of about 0.1 mm to about 0.15 mm. The gas dynamic filter 36 may provide a filter optical transmission of about 0.02 nm to about 0.05 nm during the course of evaporating at least a target of one (1) meter in length.

The gas dynamic filter 36 and focusing lens 38 are coupled together and mounted to an exterior surface of the chamber 12. Preferably, the gas dynamic filter 36 is positioned against the window 14 of the chamber 12 at an angle of about 3 degrees to about 7 degrees outward from the exterior surface of chamber 12 and in the line-of-sight of the target station 16. The focusing lens 38 may be any one of a number of focusing lenses known to one of ordinary skill in the art. Preferably, the focusing lens 38 may be about 29 millimeters to about 30 millimeters in diameter, or about 29.5 mm to about 29.9 mm in diameter, or about 29.8 mm to about 29.9 mm in diameter, or about 29.9 mm in diameter, and have a focal distance of about 45 mm to about 55 mm, or about 49 mm to about 51 mm, or about 50 mm. The separating prism 40 may be any one of a number of separating prisms as known to one of ordinary skill in the art, and preferably is a 100% reflecting prism with a right angle at the apex and having a base size of about 10 mm by about 10 mm located within a hollow rectangle of about 30 mm by about 30 mm by about 20 mm. Each photodetector 41, 43 may be disposed within a vertical plane at opposing sides of the separating prism 40.

The optical sensor 22 captures at least one image of the target within the target station 16 through the window 14. The gas dynamic filter 36 as known to one of ordinary skill in the art prevents dusting of the window 14 during the target evaporation process. The focusing lens 38 reduces the image passing through the window 14 and gas dynamic filter 36, and projects the image upon the apex of the separating prism 40. The separating prism 40 reflects a reflected image of the original image upon a first photodetector 41 and also refracts a refracted image of the original image upon a second photodetector 43. Each photodetector 41, 43 measures the intensity of light of the reflected image and the intensity of light of the refracted image. The difference in intensity or absence of a difference in intensity is registered and displayed by the preamplifier 44. In addition, the difference in intensity or absence of a difference in intensity is also communicated as at least one output signal from the optical sensor 22 to the electron module 20.

The difference in intensity or absence of a difference in intensity may be determined by comparing the light intensity measurements of the photodetectors 41, 43. The output signal produced by the optical sensor 22, and based upon the difference in intensity, indicates whether the height of the target station 16 is higher or lower than an optimal height required for stabilizing the target surface and optimal evaporation of the target. If the light intensity measurements of each image are equal, the optical sensor 22 outputs a signal equal to zero (0). This indicates the two images of the target within the target station 16 are the same, and the height of the target station remains constant and unchanged. When referring to the height of the target station 16, the surface of the molten liquid contained within the target station is the point at which the height is measured.

If the light intensity measurements of each image are not equal, this indicates the two images of the target are not the same, and the height of the target station has changed. If the second photodetector 43 measures a light intensity value greater than that of the first photodetector 41, then the height of the target station 16 is lower than an optimal height required for stabilizing the target surface and optimal evaporation of the target. In response, the system will raise the target station 16 and in turn increase the feeding rate, that is, evaporation, of the target by the electron beam of the EB-PVD apparatus. If the second photodetector 43 measures a light intensity value less than that of the first photodetector 41, then the height of the target station 16 is higher than an optimal height required for stabilizing the target surface and optimal evaporation of the target. In response, the system will lower the target station 16 and in turn reduce the feeding rate of the target by the electron beam of the EB-PVD apparatus.

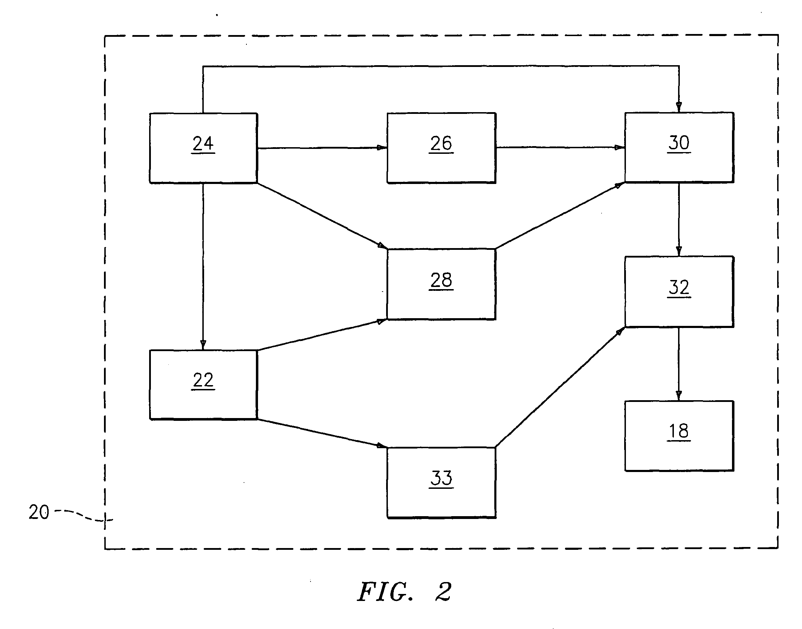

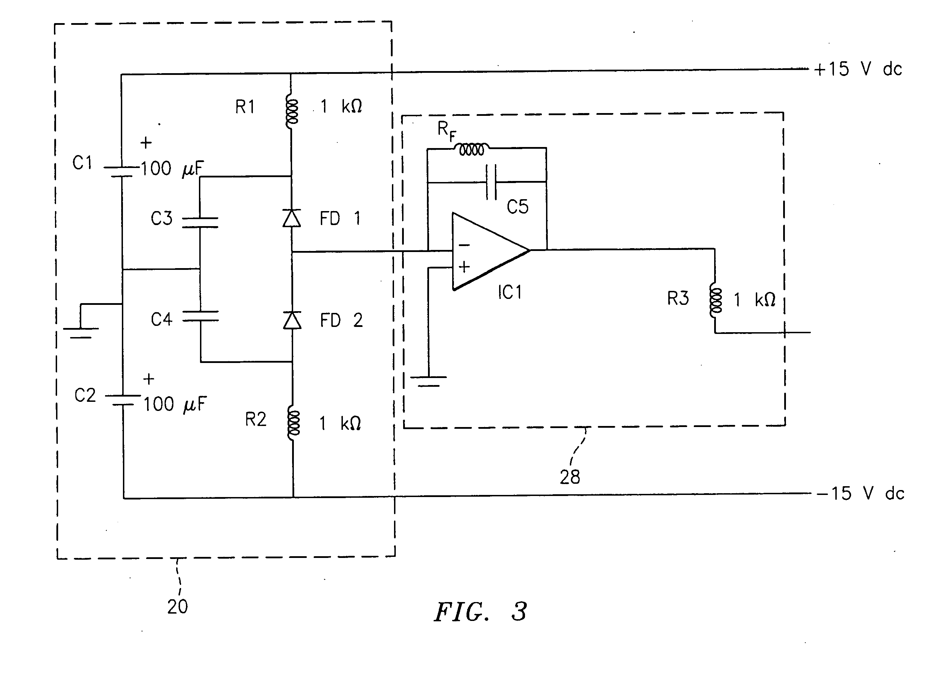

Referring now to FIGS. 2 and 3, the electron module 20 is designed to amplify the output signal(s) generated by the optical sensor 22, interpret and translate the signal(s) to correspond to the height of the target station 16, and adjust the height of the target station 16 in response to these amplified output signals. The electron module 20 may comprise a power supply 24, a driving generator 26, an amplifier 28, a pulse-width modulator 30, and a mechanism power supply 33 for supplying power to an integrator 32 and the means for moving the target station 18.

The amplifier 28 receives the output signal from the optical sensor 22. The amplifier 28 increases the output signal from about -20 decibels (dB) to about 20dB, and provides the amplified output signal to the pulse-width modulator 30. The pulse-width modulator 30 may be utilized to control the supply of the amplified output signal, that is, suppresses the current flow, to the galvanic isolator 32. The galvanic isolator 32 serves to isolate functional sections of the electrical system of the electron module 20. For example, galvanic isolator 32 may be designed to electrically isolate the optical sensor circuitry shown in FIG. 3 from the rest of the system.

In response to receiving the translated, modulated output signal, the means for moving the target station 18 receives the output signal and moves the surface of the target within the target station 16 upward or downward at an angle perpendicular to the floor 48 of the chamber 12. The means for moving the target station 18 may be powered using the mechanism power supply 33 of the electron module 20. The means for moving the target station 18 may be any mechanism capable of moving the target station in the aforementioned directions at a rate of at least 0.2 mm per second to about 0.4 mm per second.

The driving generator 26 may be any driving generator capable of operating at a frequency of about 9 kHz to about 10 kHz as known to one of ordinary skill in the art. The power supply 24 may be any power supply capable of providing about 10,000 volts (V), or 10 kV, of power as known to one of ordinary skill in the art.

The Pool Level Closed Loop Control (PLCLC) system described herein may be employed to manufacture multi-component condensates free of lamination. A multi-component target may be positioned at a first height within a chamber of the electron-beam physical vapor deposition apparatus. The multi-component target may be fed at a rate into a beam of electrons generated by the electron gun. Using the electron beam, the multi-component target may be evaporated into at least a first component evaporant and a second component evaporant. The first height of the multi-component target may be monitored using the optical sensor by measuring a difference between a first light intensity and a second light intensity of the images. Once a the optical sensor registers a change in the first height, the means for moving the target station may actuate the target station and in turn adjust the multi-component target feed rate to evenly deposit the first component evaporant and the second component evaporant upon a substrate and prevent lamination from occurring.

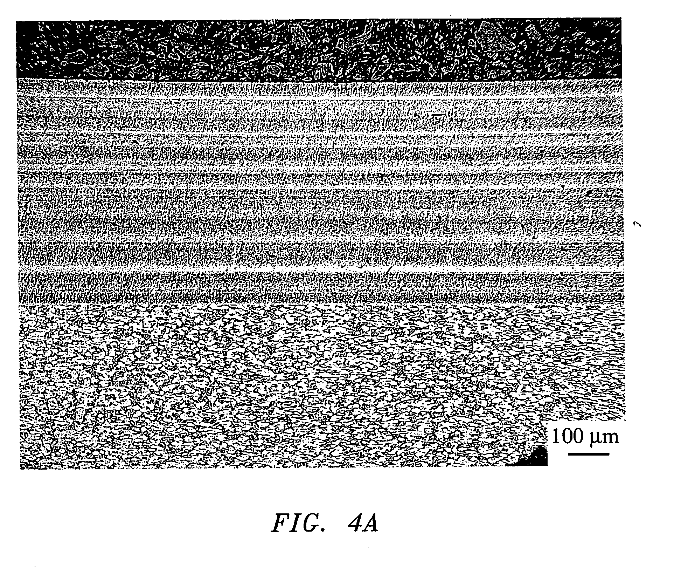

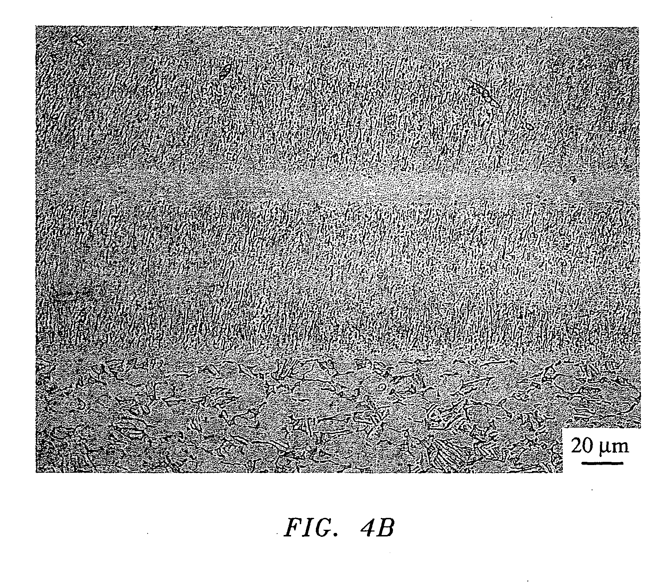

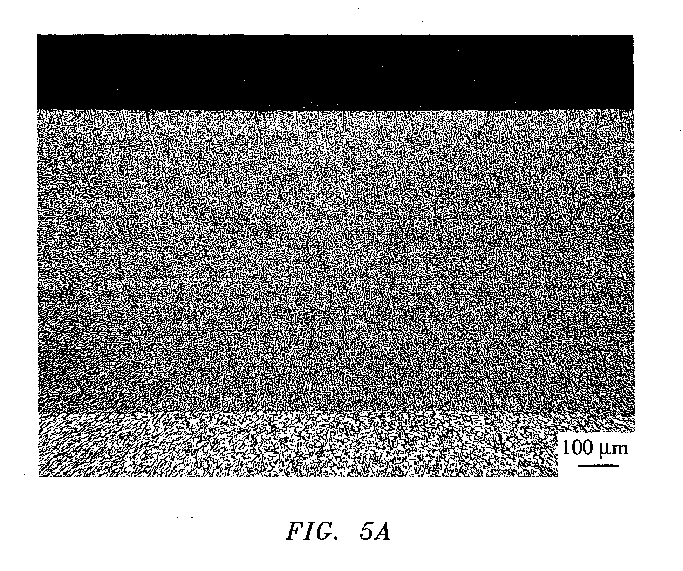

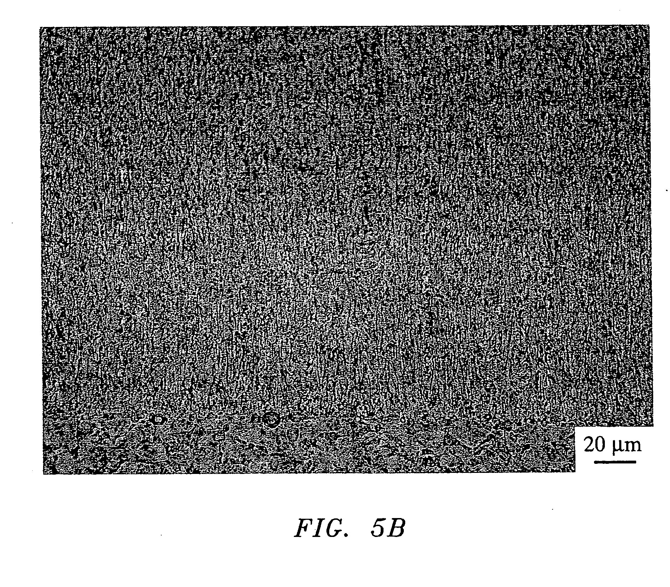

Referring now to FIG. 4, a pair of microphotographs taken at a magnification of 100x and at a magnification of 500x, respectively, of Ti-6Al-4V EBPVD condensate are shown. The Ti-6Al-4V EBPVD condensate of FIG. 4 were produced using an electron beam physical vapor deposition apparatus of the prior art. Referring now to FIG. 5, a pair of microphotographs taken at a magnification of 100x and a magnification of 500x resolution, respectively, of Ti-6Al-4V EBPVD condensate are shown. The Ti-6Al-4V EBPVD condensate of FIG. 5 was produced using an electron beam physical vapor deposition apparatus of the present invention.

As experiments show, lamination is significantly reduced or eliminated at all when the pool level is kept fixed during the process using the Pool Level Closed Loop Control (PLCLC) system described herein. As illustrated in the microphotograph of FIG. 4, the Ti-6Al-4V EBPVD condensate exhibits layers enriched in aluminum, that is, lamination. The bright bands are the aluminum enriched layers exhibiting an aluminum content of approximately 11-12 wt.%. In contrast, the Ti-6Al-4V EBPVD condensate shown in the microphotograph of FIG. 5 exhibits a highly uniform chemical composition across its cross-section, indicating lamination is practically absent. Lamination of the final product is counteracted by automatically monitoring the pool level using the Pool Level Closed Loop Control (PLCLC) system described herein.

One or more embodiments of the present invention have been described. Nevertheless, it will be understood that various modifications may be made without departing from the scope of the invention. Accordingly, other embodiments are within the scope of the following claims.

## Claims

1. A process for adjusting a feed rate in an electron-beam physical vapor deposition apparatus (10), comprising:
positioning a target (16) at a first height within a chamber (12) of an electron-beam physical vapor deposition apparatus (10);
feeding said target (16) at a rate into a beam of electrons generated by an electron gun of said electron-beam physical vapor deposition apparatus (10);
evaporating said target (16) with said beam of electrons;
monitoring said first height by measuring a difference between a first light intensity and a second light intensity of at least one image of said target (16) using an optical sensor (22) disposed proximate to said chamber (12);
determining a change in said first height; and
adjusting a target feed rate.

2. A process for manufacturing multi-component condensates free of lamination using an electron-beam physical vapor deposition apparatus (10), comprising:
positioning a multi-component target (16) at a first height within a chamber (12) of an electron-beam physical vapor deposition apparatus (10);
feeding said multi-component target (16) at a rate into a beam of electrons generated by an electron gun of said electron-beam physical vapor deposition apparatus (10);
evaporating said multi-component target with said beam of electrons into at least a first component evaporant and a second component evaporant;
monitoring said first height by measuring a difference between a first light intensity and a second light intensity of at least one image of said multi-component target (16) using an optical sensor (22) disposed proximate to said chamber (12);
determining a change in said first height;
adjusting a multi-component target feed rate to evenly deposit said first component evaporant and said second component evaporant upon a substrate; and
forming a multi-component condensate free of lamination.

3. The process of claim 1 or 2, wherein monitoring comprises the steps of:
emitting a quantity of light having said at least one image from said evaporation of said target (16);
filtering said at least one image through a gas dynamic filter (26) of said optical sensor (22) to a focal lens (38) of said optical sensor (22);
focusing said at least one image through said focal lens (38) onto a reflecting prism (40) of said optical sensor (22);
projecting said at least one image onto at least one photodetector (41, 43) of said optical sensor (22) through said prism (40);
measuring said first light intensity and said second light intensity;
determining said first light intensity measured by a first photodetector (41, 43) is not equal to said second light intensity measured by a second photodetector (41, 43);
converting the difference in said first intensity and said second intensity into an output signal of said optical sensor (22); and
determining that said first height has changed based upon said output signal.

4. The process of claim 3, wherein filtering comprises receiving said at least one image through a window (14) in said chamber disposed proximate to said gas dynamic filter (36).

5. The process of claim 3 or 4, wherein projecting comprises the steps of:
receiving at least one image;
separating said at least one image through said prism (40); and
projecting a reflected image having a first light intensity onto a first photodetector (41) of said optical sensor and a refracted image having a second light intensity onto a second photodetector (43) of said optical sensor.

6. The process of any preceding claim, wherein adjusting comprises the steps of:
determining a change in the height of said target (16);
activating a means (18) for moving said target;
increasing the height of said target (16) when said target (16) is at a second height that is lower than said first height; and
increasing said target feed rate.

7. The process of any preceding claim, further comprising the steps of:
determining a change in the height of said target (16);
activating a means (18) for moving said target;
decreasing the height of said target (16) when said target is at a second height that is higher than said first height; and
decreasing said target feed rate.

8. An electron beam physical vapor deposition apparatus (10), comprising:
a chamber (12) housing the following:
a target station (16);
means (18) for moving said target station; and
a window (14);
an optical sensor (22) disposed in connection with said chamber (12) and proximate to said window (14), wherein said optical sensor (22) comprises means for measuring a difference between a first light intensity and a second light intensity of at least one image of a target;
an electron gun disposed in connection with said chamber (12); and
an electron module (20) connected to said optical sensor (22) and said means (18) for moving said target station.

9. The apparatus of claim 8, wherein said optical sensor (22) is mounted externally to an exterior surface of said chamber (12) at an angle of about 3 degrees to about 7 degrees.

10. The apparatus of claim 8 or 9, wherein said means for measuring said difference comprises the following:
a gas dynamic filter (36) comprising a substantially tubular structure having a mesh grid disposed therein;
a focusing lens (38) having a diameter of about 29 mm to about 30 mm and a focal distance of about 45 mm to about 55 mm;
a 100% reflecting prism (40); and
a first photodetector (41) disposed adjacent to and in a vertical plane of said prism (40);
a second photodetector (43) disposed adjacent to and in said vertical plane of said prism (40) and opposite said first photodetector (41); and
a preamplifier (44) connected to said first photodetector (41) and said second photodetector (43).

11. The apparatus of claim 10, wherein said mesh grid has a mesh thickness of about 0.1 mm to about 0.15 mm.

12. The apparatus of claim 10 or 11, wherein said 100% reflecting prism (40) has a right angle at an apex and a base size of about 10 mm by about 10 mm located within a hollow rectangle having dimensions of about 30 mm by about 30 mm by about 20 mm.

13. The apparatus of any of claims 8 to 12, wherein said electron module (20) further comprises:
a power supply (24) disposed in connection with a driving generator (26), a pulse-width modulator (30), an amplifier (28), and said optical sensor (22);
an integrator (32) disposed in connection with said pulse width modulator (30) and said means (18) for moving said target station; and
a mechanism power supply (33) disposed in connection with said optical sensor (22) and said integrator (32).

14. The apparatus of any of claims 8 to 13, wherein said target station (16) comprises a receptacle.

15. The apparatus of any of claims 8 to 14, wherein said means (18) for moving said target station (16) moves said target station in a direction upwards or a direction downwards at an angle perpendicular to a floor of said chamber (12).

16. The apparatus of any of claims 8 to 15, wherein said window (14) comprises a quartz window having a diameter of about 30 mm to about 40 mm and a thickness of about 4 mm to about 10 mm.
